# EUROPEAN PATENT APPLICATION

(11) **EP 3 929 336 A1**
(43) Date of publication of application: **29.12.2021**
(21) Application number: 20760164.2
(22) Date of filing: 19.02.2020
(51) Int. Cl.: C30B 29/38, H01L 21/205

(54) **GAN CRYSTAL AND SUBSTRATE**

(30) Priority: 22.02.2019 JP 2019029968
(71) Applicant: Mitsubishi Chemical Corporation, Chiyoda-ku Tokyo 100-8251 (JP); National Institute for Materials Science, Tsukuba-shi, Ibaraki 305-0047 (JP)
(72) Inventor: ENATSU, Yuuki, Tokyo 100-8251 (JP); OSHIMA, Yuichi, Tsukuba-shi, Ibaraki 305-0047 (JP)
(74) Representative: Hoffmann Eitle
(86) International application number: PCT/JP2020/006644
(87) International publication number: WO 2020/171147

(57) **Abstract**

Provided are a GaN crystal used in a substrate for a nitride semiconductor device having a horizontal device structure such as GaN-HEMT, and a substrate used for production of a nitride semiconductor device having a horizontal device structure such as GaN-HEMT. The GaN crystal has a (0001) surface having an area of not less than 5 cm², the (0001) surface having an inclination of not more than 10° with respect to the (0001) crystal plane, wherein the Fe concentration is not less than 5×10¹⁷ atoms/cm³ and less than 1×10¹⁹ atoms/cm³, and wherein the total donor impurity concentration is less than 5×10¹⁶ atoms/cm³.

## Description

### TECHNICAL FIELD

The present invention relates to a GaN crystal and a substrate, especially to a semi-insulating GaN crystal and a substrate composed of a semi-insulating GaN crystal.

### BACKGROUND ART

GaN (gallium nitride) is a group III nitride compound, and has a wurtzite-type crystal structure belonging to the hexagonal system.

In recent years, substrates having a semi-insulating GaN layer as a surface layer, and single-crystal GaN substrates entirely composed of a semi-insulating GaN crystal have been studied as substrates for GaN-HEMTs (High Electron Mobility Transistors) (Patent Document 1).

Usually, GaN having a room-temperature resistivity of not less than 1×10⁵ Ω cm is called semi-insulating GaN.

It is known that semi-insulating GaN can be provided by doping with an impurity having an action that compensates n-type carriers, such as Fe (iron), Mn (manganese), or C (carbon). Such an impurity is sometimes called a compensating impurity.

Patent Document 1 describes that an Fe-doped semi-insulating GaN layer having a room-temperature resistivity of 8.5×10⁹ Ω cm, a (004) XRD rocking curve half-width of 33 arcsec, and a thickness of 5 µm was successfully grown on a sapphire substrate by HVPE (Hydride Vapor Phase Epitaxy) under certain specific conditions. The document describes that the dislocation density of the Fe-doped semi-insulating GaN layer was from the lower range of the order of magnitude of 1×10⁸/cm² to the higher range of the order of magnitude of 1×10⁷/cm².

### PRIOR ART DOCUMENT

### [Patent Document]

[Patent Document 1] JP 2012-246195 A

### SUMMARY OF THE INVENTION

### PROBLEMS TO BE SOLVED BY THE INVENTION

The present invention relates to a GaN crystal that can be used in a substrate for a nitride semiconductor device having a horizontal device structure such as GaN-HEMT, and a substrate that can be used for production of a nitride semiconductor device having a horizontal device structure such as GaN-HEMT.

The present inventors discovered a method of effectively suppressing an increase in the donor impurity concentration in an Fe-doped GaN crystal grown by HVPE, thereby reaching the present invention. The present inventors also discovered that a semi-insulating GaN crystal having favorable properties can be obtained by carrying out doping with Fe to an appropriate concentration while suppressing the donor impurity concentration, thereby reaching the present invention.

### MEANS FOR SOLVING THE PROBLEMS

The embodiments of the present invention include, but are not limited to, the following modes.
[1] A GaN crystal having a (0001) surface having an area of not less than 5 cm², the (0001) surface having an inclination of not more than 10° with respect to the (0001) crystal plane, wherein an Fe concentration is not less than 5×10¹⁷ atoms/cm³ and less than 1×10¹⁹ atoms/cm³, and wherein a total donor impurity concentration is less than 5×10¹⁶ atoms/cm³.
[2] The GaN crystal according to [1], wherein the Fe concentration is not more than 6×10¹⁸ atoms/cm³ or not more than 3×10¹⁸ atoms/cm³.
[3] The GaN crystal according to [1] or [2], wherein the Fe concentration is not less than 1×10¹⁸ atoms/cm³.
[4] The GaN crystal according to any one of [1] to [3], wherein a room-temperature resistivity is not less than 1×10¹¹ Ω cm, not less than 2×10¹¹ Ω cm, not less than 5×10¹¹ Ω cm, not less than 1×10¹² Ω cm, not less than 2×10¹² Ω cm, or not less than 5×10¹² Ω cm.
[5] The GaN crystal according to any one of [1] to [4], wherein the resistivity at 100°C is not less than 1×10¹⁰ Ω cm, not less than 2×10¹⁰ Ω cm, or not less than 5×10¹⁰ Ω cm.
[6] The GaN crystal according to any one of [1] to [5], wherein the resistivity at 200°C is not less than 5×10⁸ Ω cm, not less than 1×10⁹ Ω cm, or not less than 2×10⁹ Ω cm.
[7] The GaN crystal according to any one of [1] to [6], wherein the resistivity at 300°C is not less than 1×10⁸ Ω cm, not less than 2×10⁸ Ω cm, or not less than 5×10⁸ Ω cm.
[8] The GaN crystal according to [3], wherein the resistivity is not less than 1×10¹² Ω cm at room temperature, not less than 5×10¹⁰ Ω cm at 100°C, not less than 2×10⁹ Ω cm at 200°C, and not less than 5×10⁸ Ω cm at 300°C.
[9] The GaN crystal according to any one of [1] to [8], wherein the (004) XRD rocking curve full width at half maximum measured on the (0001) surface side is less than 30 arcsec, less than 25 arcsec, less than 20 arcsec, less than 18 arcsec, less than 16 arcsec, less than 14 arcsec, or less than 12 arcsec
[10] The GaN crystal according to any one of [1] to [9], wherein a threading dislocation density on the (0001) surface is less than 1×10⁷ cm⁻², less than 5×10⁶ cm⁻², or less than 1×10⁶ cm⁻².
[11] A GaN crystal having a (0001) surface having an area of not less than 5 cm², the (0001) surface having an inclination of not more than 10° with respect to the (0001) crystal plane, wherein the GaN crystal is a semi-insulating crystal, and satisfies one or more selected from the following (A) and (B):
   (A) the (004) XRD rocking curve full width at half maximum measured on the (0001) surface side is less than 30 arcsec, less than 25 arcsec, less than 20 arcsec, less than 18 arcsec, less than 16 arcsec, less than 14 arcsec, or less than 12 arcsec; and
   (B) the threading dislocation density on the (0001) surface is less than 1×10⁷ cm⁻², less than 5×10⁶ cm⁻², or less than 1×10⁶ cm⁻².
[12] The GaN crystal according to [11], wherein a room-temperature resistivity is not less than 1×10¹¹ Ω cm, not less than 2×10¹¹ Ω cm, not less than 5×10¹¹ Ω cm, not less than 1×10¹² Ω cm, not less than 2×10¹² Ω cm, or not less than 5×10¹² Ω cm.
[13] The GaN crystal according to [11] or [12], wherein the resistivity at 100°C is not less than 1×10¹⁰ Ω cm, not less than 2×10¹⁰ Ω cm, or not less than 5×10¹⁰ Ω cm.
[14] The GaN crystal according to any one of [11] to [13], wherein the resistivity at 200°C is not less than 5×10⁸ Ω cm, not less than 1×10⁹ Ω cm, or not less than 2×10⁹ Ω cm.
[15] The GaN crystal according to any one of [11] to [14], wherein the resistivity at 300°C is not less than 1×10⁸ Ω cm, not less than 2×10⁸ Ω cm, or not less than 5×10⁸ Ω cm.
[16] The GaN crystal according to [11], wherein the resistivity is not less than 1×10¹² Ω cm at room temperature, not less than 5×10¹⁰ Ω cm at 100°C, not less than 2×10⁹ Ω cm at 200°C, and not less than 5×10⁸ Ω cm at 300°C.
[17] The GaN crystal according to any one of [12] to [16], doped with Fe.
[18] The GaN crystal according to any one of [12] to [17], wherein a total donor impurity concentration is less than 5×10¹⁶ atoms/cm³.
[19] A substrate composed of the GaN crystal according to any one of [1] to [18].
[20] The substrate according to [19], which is a single-crystal GaN substrate.
[21] The substrate according to [19] or [20], composed only of the GaN crystal.
[22] The substrate according to [19], wherein a GaN layer composed of the GaN crystal is laminated on a supporting substrate.
[23] A method of producing an epitaxial wafer, the method comprising the steps of:
   providing the substrate according to any one of [19] to [22]; and
   epitaxially growing one or more nitride semiconductor layers on the provided substrate.
[24] An epitaxial wafer comprising:
   the substrate according to any one of [19] to [22]; and
   one or more nitride semiconductor layers epitaxially grown on the substrate.
[25] A method of producing a nitride semiconductor device, the method comprising the steps of:
   providing the substrate according to any one of [19] to [22]; and
   epitaxially growing one or more nitride semiconductor layers on the provided substrate.
[26] The method of producing a nitride semiconductor device according to [25], which is a method of producing a GaN-HEMT.

### EFFECT OF THE INVENTION

The present invention can provide a GaN crystal which is capable of having semi-insulating properties even at a relatively low concentration of a compensating impurity such as Fe, and which has a good crystal quality.

The present invention can provide a GaN crystal which can be suitably used in a substrate for a nitride semiconductor device having a horizontal device structure such as GaN-HEMT, and a substrate which can be suitably used for production of a horizontal nitride semiconductor device such as GaN-HEMT.

### BRIEF DESCRIPTION OF THE DRAWINGS

Fig. 1 is a perspective view illustrating a GaN crystal according to an embodiment.
Fig. 2 shows the results of measurement of the thermal conductivities of an undoped GaN crystal and a GaN crystal at an Fe concentration of 3.7×10¹⁸ atoms/cm³, which crystals were grown by HVPE using a single-crystal GaN substrate as a seed, which measurement was carried out from room temperature to 300°C.
Fig. 3 is a plan view illustrating the (0001) surface of a GaN crystal according to an embodiment, wherein the surface was divided into a square grid of 5 mm × 5 mm cells.
Fig. 4 is a perspective view illustrating a single-crystal GaN substrate according to an embodiment.
Fig. 5 is a cross-sectional view illustrating a single-crystal GaN substrate according to an embodiment.
Fig. 6 is a cross-sectional view illustrating a single-crystal GaN substrate according to an embodiment.
Fig. 7 is a schematic diagram illustrating the basic configuration of an HVPE apparatus suitable for growing a GaN crystal according to an embodiment.
Fig. 8 is a graph illustrating the relationship between the susceptor temperature of an HVPE apparatus and the impurity concentration in a grown GaN crystal.

### MODE FOR CARRYING OUT THE INVENTION

In a GaN crystal, the crystal axis parallel to [0001] and [000-1] is referred to as the c-axis; the crystal axis parallel to <10-10> is referred to as the m-axis; and the crystal axis parallel to <11-20> is referred to as the a-axis. The crystal plane perpendicular to the c-axis is referred to as the c-plane; the crystal plane perpendicular to the m-axis is referred to as the m-plane; and the crystal plane perpendicular to the a-axis is referred to as the a-plane.

In the present description, when a crystal axis, crystal plane, crystal orientation, or the like is mentioned, it means a crystal axis, crystal plane, crystal orientation, or the like of a GaN crystal unless otherwise specified.

Since the Miller indices (hkil) for a hexagonal crystal have the relationship of h + k= -i, they may be expressed in three digits (hkl). For example, the three-digit expression for (0004) is (004).

In the present description, each numerical range expressed using "... to ..." means the range including the values described before and after "to" as the lower limit and the upper limit, respectively. Thus, "A to B" means a value(s) of not less than A and not more than B.

Embodiments of the present invention are described below with reference to drawings as appropriate.

### 1. GaN Crystal

A first embodiment of the present invention relates to a GaN crystal.

The GaN crystal according to the first embodiment has a (0001) surface having an area of not less than 5 cm², and the (0001) surface has an inclination of not more than 10° (including 0°) with respect to the (0001) crystal plane. The GaN crystal according to the first embodiment may have various thicknesses, and may have various forms such as a self-standing substrate, an epitaxial layer grown on another GaN crystal, and a GaN layer laminated on a supporting substrate by a bonding technique. The shape of the GaN crystal according to the first embodiment is arbitrary, and preferably a shape with which the later-described single-crystal GaN substrate of the present invention can be obtained.

The area of the (0001) surface may be not less than 18 cm², or not less than 75 cm², or not less than 165 cm².

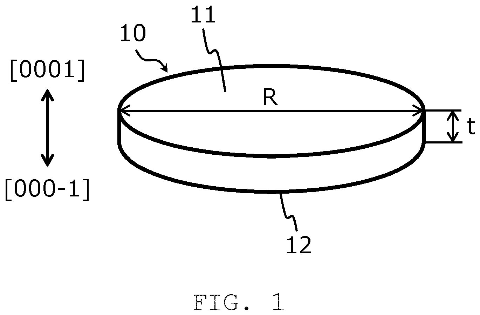

The crystal 10 illustrated in Fig. 1 is an example of the GaN crystal according to the first embodiment.

The crystal 10 has a (0001) surface 11 having Ga-polarity, and a (000-1) surface 12 having N-polarity.

In the crystal 10, the inclination of the (0001) surface 11 with respect to the (0001) crystal plane may be, for example, not less than 0° and less than 0.5°, not less than 0.5° and less than 1°, not less than 1° and less than 1.5°, not less than 1.5° and less than 2.5°, not less than 2.5° and less than 5°, or not less than 5° and less than 10°. The inclination is preferably less than 2.5°.

The fact that the surface of the crystal 10 is such a crystal plane is closely related to the fact that doping with unintentional donor impurities is suppressed or controlled in the growth process.

The entire (0001) surface 11 does not necessarily need to have the inclination within the above-described numerical range. The (0001) surface only needs to have an inclination within the above-described numerical range at least for an area of not less than 5 cm². The area of the (0001) surface having the inclination within the above-described numerical range may be not less than 18 cm², or not less than 75 cm², or not less than 165 cm².

The thickness t of the crystal 10 is usually not less than 1 µm. Although there is no upper limit, the thickness t is usually not more than 4 mm. The thickness t may be, for example, not less than 5 µm and less than 200 µm, not less than 200 µm and less than 500 µm, not less than 500 µm and less than 1 mm, or not less than 1 mm.

The (0001) surface 11 of the crystal 10 preferably has a diameter of not less than 20 mm. The surface preferably has a shape with which the later-described single-crystal GaN substrate of the present invention can be obtained. Thus, its diameter preferably exceeds the diameter R of the later-described substrate 100.

In a preferred example, the GaN crystal according to the first embodiment has an Fe concentration of not less than 5×10¹⁷ atoms/cm³ and less than 1×10¹⁹ atoms/cm³, and a total donor impurity concentration of less than 5×10¹⁶ atoms/cm³. The total donor impurity concentration is preferably less than 3×10¹⁶ atoms/cm³, more preferably less than 2×10¹⁶ atoms/cm³.

The total donor impurity concentration is the total sum of the concentrations of the donor impurities contained in the GaN crystal according to the first embodiment. Known examples of the impurities that act as donors for GaN include O (oxygen), Si (silicon), S (sulfur), Ge (germanium), and Sn (tin).

As described later, the GaN crystal according to the first embodiment is grown by HVPE (Hydride Vapor Phase Epitaxy). Therefore, the GaN crystal may contain each of O (oxygen) and Si (silicon) at a concentration in the order of 10¹⁵ atoms/cm³ or more even though these are not intentionally added. On the other hand, donor impurities other than O and Si are present at non-negligible concentrations in the GaN crystal according to the first embodiment only in cases where doping with the donor impurities is intentionally carried out. The "intentional doping" means, for example, that, for doping of a GaN crystal with a subject element, the subject element is added as a raw material in the state of a simple substance or a compound.

Therefore, unless the crystal is intentionally doped with donor impurities other than O and Si, the total donor impurity concentration in the GaN crystal according to the first embodiment may be regarded as equal to the sum of the O concentration and the Si concentration.

Not only because the GaN crystal according to the first embodiment shows a large difference between the Fe concentration and the total donor impurity concentration, but also because the total donor impurity concentration is low, it is thought that the resistivity of the GaN crystal according to the first embodiment is hardly affected by changes in the donor impurity concentration.

Another significant characteristic of the GaN crystal according to the first embodiment is that its low total donor impurity concentration enables achievement of a high resistivity at a relatively low Fe concentration.

For example, the room-temperature resistivity of the GaN crystal according to the first embodiment can reach 5×10¹² Ω cm when the Fe concentration is 3×10¹⁸ atoms/cm³, and 7×10¹² Ω cm when the Fe concentration is 6×10¹⁸ atoms/cm³.

The Fe concentration of the GaN crystal according to the first embodiment may be not more than 6×10¹⁸ atoms/cm³, or may be not more than 3×10¹⁸ atoms/cm³. The GaN crystal according to the first embodiment can have the following resistivities when the Fe concentration is not less than 1×10¹⁸ atoms/cm³.
- At room temperature, not less than 1×10¹¹ Ω cm, especially not less than 2×10¹¹ Ω cm, especially not less than 5×10¹¹ Ω cm, especially not less than 1×10¹² Ω cm.
- At 100°C, not less than 1×10¹⁰ Ω cm, especially not less than 2×10¹⁰ Ω cm, especially not less than 5×10¹⁰ Ω cm.
- At 200°C, not less than 5×10⁸ Ω cm, especially not less than 1×10⁹ Ω cm, especially not less than 2×10⁹ Ω cm.
- At 300°C, not less than 1×10⁸ Ω cm, especially not less than 2×10⁸ Ω cm, especially not less than 5×10⁸ Ω cm.

The fact that the same resistivity can be obtained even with a lower concentration of Fe which needs to be added to the GaN crystal is advantageous from the viewpoint of suppressing decreases in the crystal quality and the thermal conductivity due to the addition of Fe.

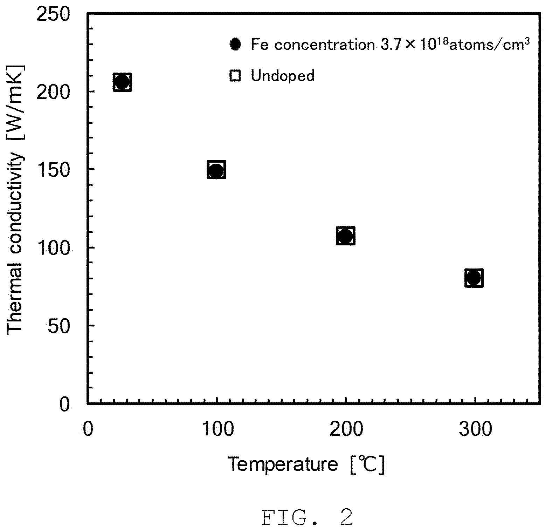

Fig. 2 shows the results of measurement of the thermal conductivities of an undoped GaN crystal and a GaN crystal at an Fe concentration of 3.7×10¹⁸ atoms/cm³, which crystals were grown by HVPE using a single-crystal GaN substrate as a seed, which measurement was carried out from room temperature to 300°C. It can be seen that the thermal conductivities were not substantially affected by the Fe doping.

The GaN crystal according to the first embodiment may contain C, which is a compensating impurity, at a concentration of not less than the lower detection limit of secondary ion mass spectrometry (SIMS) (about 5×10¹⁵ atoms/cm³), and preferably less than 1×10¹⁷ atoms/cm³, more preferably less than 5×10¹⁶ atoms/cm³.

The GaN crystal according to the first embodiment may also contain compensating impurities other than Fe and C, such as Mn (manganese), Co (cobalt), and Ni (nickel), as long as their inclusion does not cause a practical problem.

Besides the above-mentioned impurities, the GaN crystal according to the first embodiment may contain H (hydrogen), and its concentration may be, for example, in the order of 10¹⁶ to 10¹⁷ atoms/cm³.

The GaN crystal according to the first embodiment preferably satisfies one or more selected from the preferred range of the (004) XRD rocking curve full width at half maximum measured on the (0001) surface side and the preferred range of the threading dislocation density on the (0001) surface as described below. The full width at half maximum has the same meaning as the so-called half-width.

The (004) XRD rocking curve full width at half maximum measured on the (0001) surface side of the GaN crystal according to the first embodiment is preferably less than 30 arcsec, more preferably less than 25 arcsec, still more preferably less than 20 arcsec, still more preferably less than 18 arcsec, still more preferably less than 16 arcsec, still more preferably less than 14 arcsec, still more preferably less than 12 arcsec.

The (004) XRD rocking curve is an index showing the crystal quality, and measured using CuKα₁ radiation. In the measurement, an X-ray tube is operated, for example, at a voltage of 45 kV and a current of 40 mA.

For making X-ray incident on the (0001) surface in the measurement of the (004) XRD rocking curve, the plane of incidence of X-ray may be set perpendicular to the a-axis or the m-axis.

The X-ray beam size may be set such that, when the angle of incidence (the angle between the reflection plane and the X-ray) is set to 90°, that is, when X-ray is made incident perpendicularly to the (004) plane, which is the reflection plane, the size of the irradiation area on the (0001) surface is 5 mm in the direction parallel to the ω-axis, and 1 mm in the direction perpendicular to the ω-axis. The ω-axis is the rotation axis of the sample in the rocking curve measurement.

When the X-ray beam size is set in this manner, ω in the (004) XRD rocking curve measurement is about 36.5°, so that the size of the irradiation area is about 1.7×5 mm².

The threading dislocation density of the GaN crystal according to the first embodiment is usually less than 1×10⁷ cm⁻², preferably less than 5×10⁶ cm⁻², more preferably less than 1×10⁶ cm⁻², still more preferably less than 5×10⁵ cm⁻², still more preferably less than 1×10⁵ cm⁻².

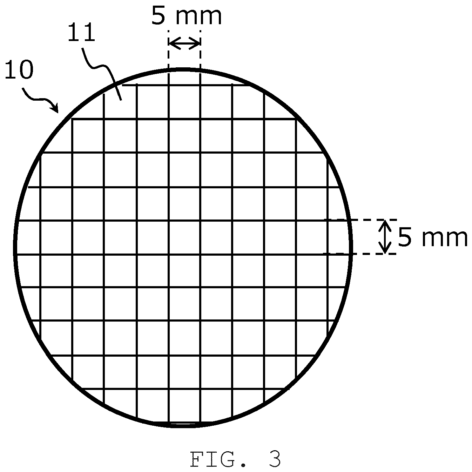

In an especially preferred example, when the (0001) surface of the GaN crystal according to the first embodiment is divided into a square grid of 5 mm × 5 mm cells as illustrated in Fig. 3, at least one square area of 100 µm × 100 µm without threading dislocation is present in each 5 mm × 5 mm cell.

There are three kinds of threading dislocations: edge threading dislocation, screw threading dislocation, and mixed threading dislocation. In the present description, these are not distinguished from each other, and collectively referred to as threading dislocation.

The GaN crystal according to the first embodiment is a semi-insulating crystal, and has a low carrier concentration. Therefore, the presence or absence, or the density, of threading dislocation on its (0001) surface cannot be investigated by observation of a CL (cathodoluminescence) image.

The presence or absence, and the density, of threading dislocation in the GaN crystal according to the first embodiment can be investigated by 1 hour of etching with sulfuric acid at a concentration of 89% heated to 270°C. Etch pits formed on the (0001) surface by the etching correspond to the threading dislocation, and their density is equivalent to the threading dislocation density. This has been confirmed by investigation of the correspondence relationship between etch pits formed under the same conditions by etching of a conductive GaN crystal grown by HVPE and dark points that appear in a cathodoluminescence (CL) image.

The method of obtaining the GaN crystal according to the first embodiment is not limited. More specifically, the GaN crystal may be obtained by the later-mentioned GaN crystal growth method or the like.

### 2. Single-Crystal GaN Substrate

A second embodiment of the present invention relates to a substrate composed of a GaN crystal, especially to a single-crystal GaN substrate. The single-crystal GaN substrate may be a self-standing substrate composed only of a GaN single crystal.

At least part of the GaN substrate according to the second embodiment is constituted by the GaN crystal according to the first embodiment described above. Thus, the GaN substrate according to the second embodiment is capable of similarly producing the effect which can be produced by the GaN crystal according to the first embodiment.

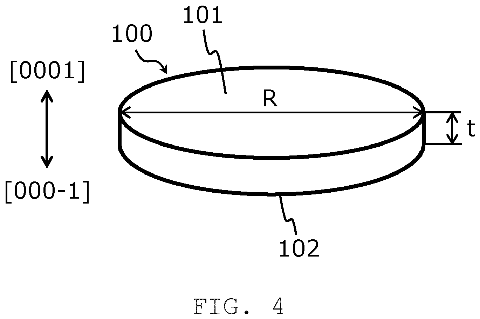

The substrate 100 illustrated in Fig. 4 is an example of the GaN substrate according to the second embodiment, and has a (0001) surface 101 having Ga-polarity, and a (000-1) surface 102 having N-polarity.

The diameter R of the substrate 100 is usually not less than 20 mm, typically 25 to 27 mm (about 1 inch), 50 to 55 mm (about 2 inches), 100 to 105 mm (about 4 inches), 150 to 155 mm (about 6 inches), or the like.

The thickness t of the substrate 100 is set to a value at which handling of the substrate 100 is not difficult, depending on the diameter R. For example, when the diameter R of the substrate 100 is about 2 inches, the thickness t is preferably 250 to 500 µm, more preferably 300 to 450 µm.

Of the two large-area surfaces of the substrate 100, the surface used for the epitaxial growth of the nitride semiconductor layer, which corresponds to the front side, is the (0001) surface 101. The (0001) surface 101 is mirror-finished, and its root mean square (RMS) roughness as measured by AFM is usually less than 2 nm, preferably less than 1 nm, more preferably less than 0.5 nm in a measurement area of 2 µm × 2 µm.

Since the (000-1) surface 102 is the back side, it may be either mirror-finished or matted.

The substrate 100 may have a chamfered edge.

When necessary, the substrate 100 may be marked in various ways, for example, with an orientation flat or notch for indicating the orientation of the crystal, or with an index flat for simplifying identification of the front side and the back side.

The substrate 100 has a disk shape. However, in modification examples, the (0001) surface 101 and the (000-1) surface 102 may have, for example, a square shape, a rectangular shape, a hexagonal shape, an octagonal shape, or an elliptic shape, or may be amorphous.

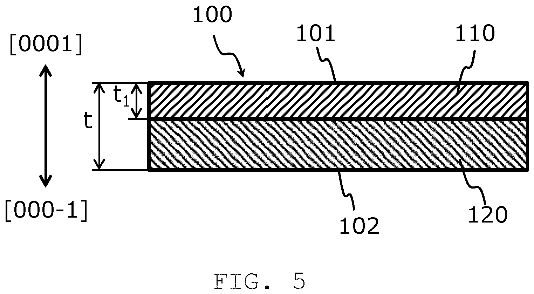

Fig. 5 illustrates a cross-sectional view of the substrate 100 wherein the substrate 100 is cut in a plane perpendicular to the (0001) surface 101.

In the substrate 100, a first area 110 including the (0001) surface 101 is composed of the GaN crystal according to the first embodiment.

In cases where the thickness t₁ of the first area 110 is smaller than the thickness t of the substrate 10, the substrate 100 has a second area 120 in the side of the (000-1) surface 102 as illustrated in Fig. 5.

The second area 120 is composed of a GaN crystal having a room-temperature resistivity of less than 1 × 10⁵ Ω cm, that is, a non-semi-insulating GaN crystal.

The total concentration of compensating impurities in the second area 120 is usually lower than that in the first area 110. The second area 120 may have, near the border with the first area 110, an area in which the total concentration of compensating impurities increases in a stepwise manner or continuously toward the first area 110.

The substrate 100 having the first area 110 and the second area 120 can be produced by forming the second area 120 on the first area 110 by epitaxial growth, or by forming the first area 110 on the second area 120 by epitaxial growth.

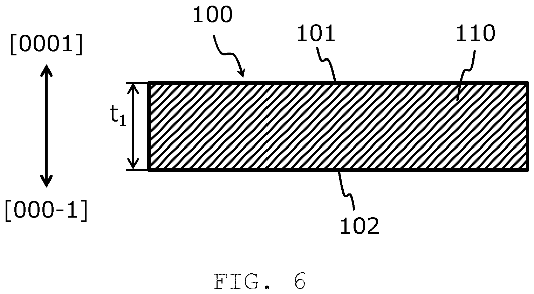

In one example, as illustrated in Fig. 6, the thickness of the substrate 100 may be the same as the thickness t₁ of the first area 110. In other words, the substrate 100 may be composed only of the GaN crystal according to the first embodiment.

### 3. GaN Crystal Growth Method

The GaN crystal according to the first embodiment is usually grown by HVPE. An HVPE apparatus suitable for the growth of the GaN crystal according to the first embodiment, and the conditions that may be used for the growth of the GaN crystal according to the first embodiment using the apparatus, are described below.

### 3.1. HVPE Apparatus

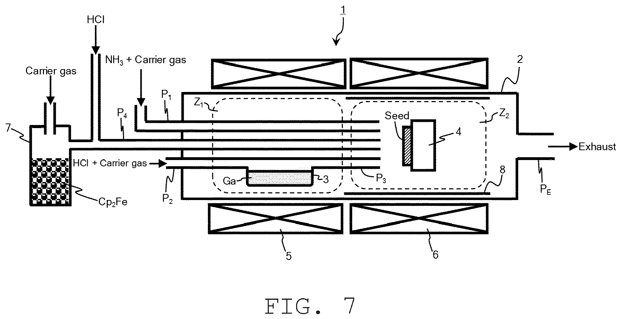

Fig. 7 is a schematic diagram illustrating the basic configuration of an HVPE apparatus suitable for the growth of the GaN crystal according to the first embodiment.

As illustrated in Fig. 7, the HVPE apparatus 1 comprises: a hot-wall reactor 2; a gallium reservoir 3 and a susceptor 4 placed in the reactor; and a first heater 5, a second heater 6, and a vaporizer 7 placed outside the reactor. Each of the first heater 5 and the second heater 6 is arranged in a circular pattern so as to surround the reactor 2.

The reactor 2 is a quartz tube chamber. In the reactor 2, there is a first zone Z₁, which is mainly heated by the first heater 5, and a second zone Z₂, which is mainly heated by the second heater 6. An exhaust pipe P_{E} is connected to the reactor end in the side of the second zone Z₂.

The gallium reservoir 3 placed in the first zone Z₁ is a container having a gas inlet and a gas outlet. It may be formed with carbon or quartz, or may be formed by combination of a carbon component and a quartz component.

The susceptor 4 placed in the second zone Z₂ is, for example, but does not necessarily need to be, formed with graphite. Alternatively, the susceptor 4 may be formed with a metal having excellent heat resistance and corrosion resistance, such as W (tungsten) or Mo (molybdenum), or may be formed with a heat-resistant ceramic such as SiC whose surface is coated with pyrolytic graphite. A mechanism for rotating the susceptor 4 may be arbitrarily provided.

In the second zone Z₂, a sleeve 8 inserted in the reactor 2 prevents contact of the inner wall of the reactor 2 with the gas flowing in the reactor 2. The sleeve 8 is formed with a flexible graphite sheet, and has an outer diameter slightly smaller than the inner diameter of the reactor 2. The sleeve 8 may be in contact with or adhering to the reactor 2, or a small gap may be formed therebetween. The inventors think that the placement of the sleeve 8 is effective for reduction of the Si concentration in the grown GaN crystal. This is because the presence of the sleeve 8 suppresses introduction of Si element derived from the reactor 2, which is formed with a quartz tube, into the GaN crystal.

In the vaporizer 7, solid ferrocene [bis(cyclopentadienyl)iron] placed in a container is vaporized by heating with a carrier gas supplied. The vaporized ferrocene is transported into the reactor 2 by the carrier gas.

When the GaN crystal is grown using the HVPE apparatus 1, metallic gallium is placed in the gallium reservoir 3, and a seed is placed on the susceptor 4. The first zone Z₁ and the second zone Z₂ are heated with the first heater 5 and the second heater 6, respectively. NH₃ (ammonia) diluted with a carrier gas is supplied to the second zone Z₂ through an ammonia introduction pipe P₁, and HCl (hydrogen chloride) diluted with a carrier gas is supplied to the gallium reservoir 3 through a hydrogen chloride introduction pipe P₂. This HCl reacts with the metallic gallium in the gallium reservoir 3, and the resulting GaCl (gallium chloride) is transported to the second zone Z₂ through a gallium chloride introduction pipe P₃. In the second zone Z₂, NH₃ reacts with GaCl, and the resulting GaN is crystallized on the seed.

When the GaN crystal grown on the seed is doped with Fe, ferrocene vaporized in the vaporizer 7 is mixed with HCl, and then introduced into the reactor 2 through a dopant introduction pipe P₄. It is thought that the ferrocene reacts with the HCl in the dopant introduction pipe P₄, and that the product iron chloride and/or a pyrolysis product thereof is/are released to the second zone Z₂ as a dopant source.

In the ammonia introduction pipe P₁, the hydrogen chloride introduction pipe P₂, the gallium chloride introduction pipe P₃, and the dopant introduction pipe P₄, the portions exposed to high temperature in the reactor may be formed with quartz.

In particular, since the nozzle of the gallium chloride introduction pipe P₃ is positioned in the second zone Z₂, which is heated at a higher temperature than the first zone Z₁, and since H₂ as a by-product of the GaCl-generating reaction flows through the nozzle, the nozzle of the gallium chloride introduction pipe P₃ is preferably formed with a carbon material such as pyrolytic graphite or with W (tungsten) rather than quartz.

As a result of an experiment by the present inventors using an HVPE apparatus having the same basic configuration as the HVPE apparatus 1, use of a pyrolytic graphite tube instead of a quartz tube as the nozzle of the gallium chloride introduction pipe resulted in a decrease in the Si concentration by half in a GaN crystal grown using only N₂ as the carrier gases without intentional doping. It should be noted that the O concentration in the GaN crystal was not affected by the change in the nozzle.

In Fig. 7, the nozzle of the ammonia introduction pipe P₁ and the nozzle of the gallium chloride introduction pipe P₃ are independently provided. However, in a preferred example, a double-pipe nozzle having the former as the outer pipe and the latter as the inner pipe may be employed. The diameter of the outer pipe in this case may be increased to the same size as the inner diameter of the reactor.

In Fig. 7, the nozzle of the gallium chloride introduction pipe P₃ and the nozzle of the dopant introduction pipe P₄ are independently provided. However, in a preferred example, GaCl and the dopant source may be mixed together before being released into the second zone Z₂ through a common nozzle in order to allow uniform doping of the growing GaN crystal with Fe. In view of this, the nozzle of the dopant introduction pipe P₄ may be placed in the gallium chloride introduction pipe P₃.

In the HVPE apparatus 1 illustrated in Fig. 7, the reactor 2 may be provided as a vertical reactor instead of the horizontal reactor without changing the basic configuration. The vertical reactor provided may have a configuration in which the raw material gas flows downward in the reactor, or a configuration in which the raw material gas flows in the opposite direction.

### 3.2. Seed

When the GaN crystal according to the embodiment is grown, a c-plane single-crystal GaN substrate is preferably used as the seed.

Since the c-plane single-crystal GaN substrate has a dislocation density of less than 1×10⁷ cm⁻², an Fe-doped GaN layer having favorable surface flatness can be grown on its (0001) surface.

When a GaN/sapphire template is used as the seed, the morphology of the growth surface of an Fe-doped GaN layer is poorer than that of an undoped GaN layer grown on the same seed. However, both an undoped GaN layer and a GaN layer at an Fe concentration of about 6×10¹⁸ cm⁻³ grown on c-plane single-crystal GaN substrates by the present inventors had flat surfaces, and no distinguishable difference in the morphology was found therebetween under a differential interference microscope.

The present inventors consider that the morphology of the growth surface may affect the O (oxygen) concentration in a GaN crystal. The concentration of O incorporated in a GaN layer growing in the [0001] direction may be different by not less than 50 times between cases where the growth surface is flat and cases where the growth surface is irregular, even under the same growth conditions. In such a GaN layer, the O concentration is low when the growth surface is a flat plane parallel to the (0001) crystal plane.

As the seed, a GaN substrate prepared by a gas-phase process such as HVPE, or a GaN substrate prepared by a liquid-phase process such as an ammonothermal process may be used. The ammonothermal process may be either an acidic ammonothermal process or a basic ammonothermal process.

In a preferred example, a c-plane single-crystal GaN substrate grown by an acidic ammonothermal process using NH₄F (or HF) and NH₄I (or HI) as mineralizers, the substrate having a (004) XRD rocking curve full width at half maximum of less than 20 arcsec, may be employed as the seed. For a production procedure for such a c-plane single-crystal GaN substrate, one may refer to WO 2018/030311.

### 3.3. Carrier Gases

When the GaN crystal according to the embodiment is grown by HVPE, use of H₂ (hydrogen gas) as a carrier gas is preferably avoided as much as possible. Preferably, only an inert gas such as N₂ (nitrogen gas) or a noble gas is used as the carrier gases. The inert gas is preferably N₂.

The reason why use of H₂ as a carrier gas is not preferred is that H₂ contributes to degradation of quartz, which is a material of the reactor and the pipes, and hence that H₂ is thought to be the main cause of unintentional Si doping of the GaN crystal to be grown.

### 3.4. Temperature Conditions

When the HVPE apparatus 1 illustrated in Fig. 7 is used, the impurity concentration in the growing GaN crystal is not largely affected by the temperature of the first zone Z₁.

According to an experiment using an HVPE apparatus having the same basic configuration as the HVPE apparatus 1 (using only N₂ as the carrier gases), when the temperature of the gallium reservoir was fixed to 1030°C, and the susceptor temperature was changed within the range of 440°C to 840°C, no substantial change in the Si concentration, the O concentration, the C concentration, or the H concentration was found for a GaN crystal grown without intentional doping. Moreover, the growth rate of the GaN crystal was almost the same.

However, when the temperature of the gallium reservoir was not less than 900°C, the Si concentration and the C concentration tended to increase in the grown GaN crystal.

On the other hand, the temperature T₂ of the second zone Z₂ has a non-small effect on the impurity concentration in the growing GaN crystal.

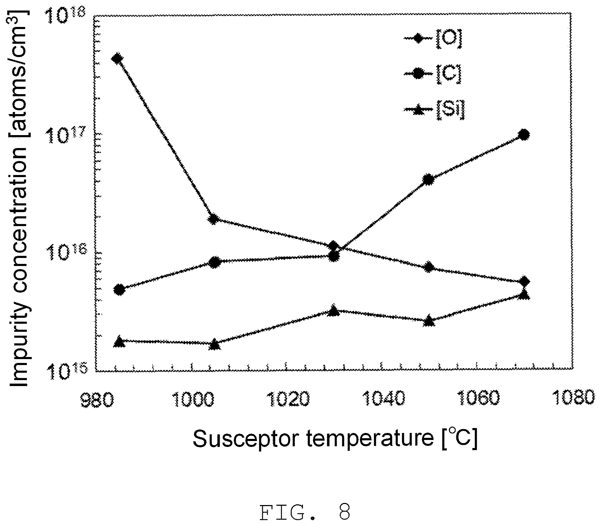

Fig. 8 illustrates the relationship between the susceptor temperature and the impurity concentration in the grown GaN crystal, which relationship was obtained by an experiment using an HVPE apparatus having the same basic configuration as the HVPE apparatus 1.

In this experiment, the temperature of the gallium reservoir was fixed to 840°C, and the susceptor temperature was changed within the range of 985°C to 1070°C. As the carrier gases, only N₂ was used. GaCl and NH₃ were supplied into the reactor at flow rates of 40 sccm and 500 seem, respectively, to grow a GaN crystal on a single-crystal c-plane GaN substrate without intentional doping.

As illustrated in Fig. 8, the O concentration in the grown GaN crystal decreased by an order of magnitude from the order of 10¹⁷ atoms/cm³ to the order of 10¹⁶ atoms/cm³ when the susceptor temperature was increased from 985°C to 1005°C. The O concentration decreased to the order of 10¹⁵ atoms/cm³ when the susceptor temperature was further increased. It is assumed that, as the temperature increased, the surface flatness of the growing GaN layer was improved, so that incorporation of O became less likely to occur.

On the other hand, although the Si concentration in the grown GaN crystal tended to increase as the susceptor temperature increased, the Si concentration never exceeded 5×10¹⁵ atoms/cm³.

The C concentration in the grown GaN crystal also tended to increase as the susceptor temperature increased.

### 3.5. Fe Doping

Using an HVPE apparatus having the same basic configuration as the HVPE apparatus 1, the present inventors carried out an experiment in which the flow rate of the carrier gas supplied to the vaporizer was changed while the temperature of ferrocene was maintained at 30°C. As a result, the Fe concentration in a GaN crystal grown at 1030°C on a single-crystal c-plane GaN substrate varied within the range of 6×10¹⁷ atoms/cm³ to 6×10¹⁸ atoms/cm³ almost in proportion to the flow rate of the carrier gas. On the other hand, the Si concentration, the O concentration, and the C concentration of the GaN crystal were not related to the flow rate of the carrier gas. In this experiment, not only the carrier gas supplied to the vaporizer, but also all other carrier gases supplied to the reactor were N₂.

To the conditions other than those described above, common conditions in HVPE may be applied regarding the growth method for the GaN crystal.

### 4. Uses of Substrate

The single-crystal GaN substrate according to the second embodiment can be preferably used for production of a nitride semiconductor device, especially a nitride semiconductor device having a horizontal device structure.

A nitride semiconductor is also called a nitride-based group III-V compound semiconductor, group III nitride-based compound semiconductor, GaN-based semiconductor, or the like, and includes not only GaN, but also compounds produced by partially or entirely substituting the gallium of GaN with another group 13 element (B, Al, In, or the like).

A typical example of a nitride semiconductor device having a horizontal device structure is GaN-HEMT, but a horizontal device structure may be employed also in electronic devices other than HEMTs, such as bipolar transistors; and light-emitting devices such as light-emitting diodes (LEDs) and laser diodes (LDs).

Examples of a substrate composed of the GaN crystal according to the first embodiment include not only the single-crystal GaN substrate according to the second embodiment, but also a substrate prepared by laminating a GaN layer composed of the GaN crystal according to the first embodiment on a supporting substrate by a bonding technique. Such a substrate can be used for the same uses as those for the single-crystal GaN substrate according to the second embodiment.

The GaN crystal according to the first embodiment and the GaN substrate according to the second embodiment may be used as epitaxial wafers by lamination with one or more epitaxially grown nitride semiconductor layers on the crystal or the substrate.

### 5. Experimental Results

### 5.1. Experiment 1

### (1) Growth of Fe-Doped GaN Crystal

As a seed, a c-plane single-crystal GaN substrate having a dislocation density of about 2×10⁶ to 4×10⁶ cm⁻² grown by HVPE was provided.

On the (0001) surface of the c-plane single-crystal GaN substrate, a GaN crystal layer was grown by the following procedure using an HVPE apparatus having the same basic configuration as the HVPE apparatus illustrated in Fig. 7.

After setting the seed on the susceptor, the reactor was heated while N₂ and NH₃ were introduced into the reactor at 2700 sccm and 500 seem, respectively.

Subsequently, when the gallium reservoir temperature and the susceptor temperature reached 850°C and 1030°C, respectively, the temperatures were kept constant, and GaCl and NH₃ were supplied at flow rates of 40 sccm and 500 seem, respectively, to begin the growth of the GaN crystal. Only N₂ was used as the carrier gases supplied during the growth.

At the same time as the beginning of the growth of the GaN crystal, HCl was allowed to flow through the dopant introduction pipe at 3 seem.

Fe doping was begun 1 minute after the beginning of the growth, by supplying N₂ as a carrier gas into the vaporizer. The flow rate of the carrier gas supplied to the vaporizer was gradually increased for 1 minute to 10 seem. In the vaporizer, ferrocene placed in a container was retained at 35°C in a thermostat. The growth rate of the Fe-doped GaN crystal layer was 1.7 µm/min.

### (2) Preparation of GaN Substrate

The GaN layer grown in (1) was sliced parallel to the c-plane, to obtain a wafer. Both sides of the wafer were planarized by grinding, and the damage layers generated by the grinding were removed by CMP (Chemical Mechanical Polishing), to prepare a c-plane single-crystal GaN substrate composed only of an Fe-doped GaN crystal, which has a thickness of 400 µm and whose (0001) surface has a square shape of 2.5 cm × 2.5 cm.

### (3) Impurity Concentrations

Impurity concentrations of the c-plane single-crystal GaN substrate prepared in (2) were measured by SIMS. As a result, the Fe concentration was found to be 1.5×10¹⁸ atoms/cm³; the Si concentration was found to be 1.3×10¹⁶ atoms/cm³; the O concentration was found to be 8.0×10¹⁵ atoms/cm³; and the C concentration was found to be 3.6×10¹⁶ atoms/cm³.

### (4) Evaluation of Resistivity by Direct-Current Three-Terminal Method

The resistivity of the c-plane single-crystal GaN substrate prepared in (2) was measured by the direct-current three-terminal method according to the following procedure.

A circular main electrode and a guard electrode surrounding the main electrode were formed on the (0001) surface of the substrate, and a counter electrode was formed on the (000-1) surface of the substrate. These electrodes were formed by drying an Ag paste, applied by screen printing, in air for 12 hours at 100°C.

The measurement was carried out in an N₂ atmosphere at room temperature, 100°C, 200°C, and 300°C. The substrate was kept at each temperature for 15 minutes. Thereafter, direct voltage was applied thereto for charging for 1 minute, and then the current was measured to determine the volume resistivity. The results are shown below in Table 1.

**[Table 1]**

| Sample thickness t (cm) | Main electrode diameter D₁ (cm) | Guard electrode diameter D₂ (cm) | Electrode gap spacing g (cm) | Electrode effective area S (sm²) | Temperature (° C) | Applied voltage V (V) | Volume resistivity Rᵥ (Ω) | Resistivity ρᵥ (Ωcm) |
|---|---|---|---|---|---|---|---|---|
| 0.043 | 1.45 | 1.60 | 0.15 | 1.83 | 26 | 500 | 6.78 × 10¹⁰ | 2.9 × 10¹² |
| | | | | | 100 | 500 | 2.96 × 10⁹ | 1.3 × 10¹¹ |
| | | | | | 200 | 500 | 1.33 × 10⁸ | 5.7 × 10⁹ |
| | | | | | 300 | 500 | 3.45 × 10⁷ | 1.5 × 10⁹ |

### 5.2. Experiment 2

By almost the same procedure as in experiment 1, c-plane single-crystal GaN substrates were prepared. However, in the present experiment 2, the flow rate of the carrier gas supplied to the vaporizer during the growth of the Fe-doped GaN layer was increased to prepare c-plane single-crystal GaN substrates having higher Fe concentrations.

The c-plane single-crystal GaN substrates prepared, which had Fe concentrations of 3×10¹⁸ atoms/cm³ and 6×10¹⁸ atoms/cm³, showed room-temperature resistivities of 5×10¹² Ω cm and 7×10¹² Ω cm, respectively, as measured by the double-ring method. The concentrations of the impurities other than Fe were the same as those in the c-plane single-crystal GaN substrate produced in experiment 1.

There was no difference in the measured value of the room-temperature resistivity between the direct-current three-terminal method and the double-ring method. The room-temperature resistivity of the c-plane single-crystal GaN substrate at an Fe concentration of 1.6×10¹⁸ atoms/cm³ was 2.9×10¹² Ω cm as measured by the double-ring method at an applied voltage of 500 V.

### 5.3. Experiment 3

### (1) Preparation of GaN Substrate

An Fe-doped c-plane single-crystal GaN substrate was prepared by almost the same procedure as in experiment 1 except that a c-plane single-crystal GaN substrate grown by an ammonothermal process using NH₄F and NH₄I as mineralizers, the substrate having a (004) XRD rocking curve full width at half maximum of about 10 arcsec, was used as the seed, and that the flow rate of the carrier gas supplied to the vaporizer during the growth of the Fe-doped GaN layer was increased.

### (2) (004) XRD Rocking Curve Full Width at Half Maximum

The (004) XRD rocking curve full width at half maximum of the Fe-doped GaN substrate prepared in (1) was measured using an X-ray diffractometer [PANalytical X'Pert Pro MRD, manufactured by Spectris Co., Ltd.].

In the measurement, a line focus CuKα source was operated at 45 kV at 40 mA, and CuKα₁ ray was obtained using a Ge (440) four-crystal symmetric monochromator. The optical system used was collimating optics, and a 1/2 slit, an X-ray mirror, and a cross-slit of w 1 mm × h 1 mm were used for the incident side. As a detector, a semiconductor pixel detector PIXcel^{3D} (registered trademark) was used in the 0D mode. The angular resolution was 5 to 6 arcsec.

X-ray was made incident on the (0001) surface of the sample such that the incident plane was perpendicular to an m-axis. The beam size was set such that the size of the irradiation area was 1 × 5 mm² when the incident angle was 90°, that is, when X-ray was made incident perpendicularly to the Ga-polarity plane.

The average based on measurement at 5 positions on the sample surface with an area of 6.3 cm² was 10 arcsec. According to the value of the (004) XRD rocking curve full width at half maximum, it can be assumed that the dislocation density of the Fe-doped GaN substrate prepared in the present experiment 3 does not exceed the order of 10⁵ cm⁻² at the highest estimate.

### (3) Impurity Concentrations

Impurity concentrations of the c-plane single-crystal GaN substrate prepared in (1) were measured by SIMS. As a result, the Fe concentration was found to be 5.4×10¹⁸ atoms/cm³; the Si concentration was found to be 1.1×10¹⁶ atoms/cm³; the O concentration was found to be 8.3×10¹⁵ atoms/cm³; and the C concentration was found to be 3.4×10¹⁶ atoms/cm³.

### (4) Evaluation of Resistivity

As a result of measurement of the room-temperature resistivity of the c-plane single-crystal GaN substrate prepared in (1) by the double-ring method, the room-temperature resistivity was found to be 7×10¹² Ω cm.

The present invention was described above by way of concrete embodiments. However, each embodiment was presented as an example, and does not limit the scope of the present invention. Each embodiment described in the present description may be modified in various ways without departing from the spirit of the invention, and may be combined with characteristics illustrated by other embodiments as long as the invention can be carried out.

### DESCRIPTION OF SYMBOLS

- 1.: HVPE apparatus
- 2.: Reactor
- 3.: Gallium reservoir
- 4.: Susceptor
- 5.: First heater
- 6.: Second heater
- 7.: Vaporizer
- 8.: Sleeve
- 10.: Crystal
- 11.: (0001) surface
- 12.: (000-1) surface
- 100.: Substrate
- 101.: (0001) surface
- 102.: (000-1) surface
- 110.: First area
- 120.: Second area

## Claims

1. A GaN crystal having a (0001) surface having an area of not less than 5 cm², the (0001) surface having an inclination of not more than 10° with respect to the (0001) crystal plane, wherein an Fe concentration is not less than 5×10¹⁷ atoms/cm³ and less than 1×10¹⁹ atoms/cm³, and wherein a total donor impurity concentration is less than 5×10¹⁶ atoms/cm³.

2. The GaN crystal according to claim 1, wherein the Fe concentration is not more than 6×10¹⁸ atoms/cm³.

3. The GaN crystal according to claim 1 or 2, wherein the Fe concentration is not less than 1×10¹⁸ atoms/cm³.

4. The GaN crystal according to any one of claims 1 to 3, wherein a room-temperature resistivity is not less than 1×10¹¹ Ω cm.

5. The GaN crystal according to any one of claims 1 to 4, wherein the resistivity at 100°C is not less than 1×10¹⁰ Ω cm.

6. The GaN crystal according to any one of claims 1 to 5, wherein the resistivity at 200°C is not less than 5×10⁸ Ω cm.

7. The GaN crystal according to any one of claims 1 to 6, wherein the resistivity at 300°C is not less than 1×10⁸ Ω cm.

8. The GaN crystal according to claim 3, wherein the resistivity is not less than 1×10¹² Ω cm at room temperature, not less than 5×10¹⁰ Ω cm at 100°C, not less than 2×10⁹ Ω cm at 200°C, and not less than 5×10⁸ Ω cm at 300°C.

9. The GaN crystal according to any one of claims 1 to 8, wherein the (004) XRD rocking curve full width at half maximum measured on the (0001) surface side is less than 30 arcsec.

10. The GaN crystal according to any one of claims 1 to 9, wherein a threading dislocation density on the (0001) surface is less than 1×10⁷ cm⁻².

11. A GaN crystal having a (0001) surface having an area of not less than 5 cm², the (0001) surface having an inclination of not more than 10° with respect to the (0001) crystal plane, wherein the GaN crystal is a semi-insulating crystal, and satisfies one or more selected from the following (A) and (B):
(A) the (004) XRD rocking curve full width at half maximum measured on the (0001) surface side is less than 30 arcsec; and
(B) the threading dislocation density on the (0001) surface is less than 1×10⁷ cm⁻².

12. The GaN crystal according to claim 11, wherein a room-temperature resistivity is not less than 1×10¹¹ Ω cm.

13. The GaN crystal according to claim 11 or 12, wherein the resistivity at 100°C is not less than 1×10¹⁰ Ω cm.

14. The GaN crystal according to any one of claims 11 to 13, wherein the resistivity at 200°C is not less than 5×10⁸ Ω cm.

15. The GaN crystal according to any one of claims 11 to 14, wherein the resistivity at 300°C is not less than 1×10⁸ Ω cm.

16. The GaN crystal according to claim 11, wherein the resistivity is not less than 1×10¹² Ω cm at room temperature, not less than 5×10¹⁰ Ω cm at 100°C, not less than 2×10⁹ Ω cm at 200°C, and not less than 5×10⁸ Ω cm at 300°C.

17. The GaN crystal according to any one of claims 12 to 16, doped with Fe.

18. The GaN crystal according to any one of claims 12 to 17, wherein a total donor impurity concentration is less than 5×10¹⁶ atoms/cm³.

19. A substrate composed of the GaN crystal according to any one of claims 1 to 18.

20. The substrate according to claim 19, which is a single-crystal GaN substrate.

21. The substrate according to claim 19 or 20, composed only of the GaN crystal.

22. The substrate according to claim 19, wherein a GaN layer composed of the GaN crystal is laminated on a supporting substrate.

23. A method of producing an epitaxial wafer, the method comprising the steps of:
providing the substrate according to any one of claims 19 to 22; and
epitaxially growing one or more nitride semiconductor layers on the provided substrate.

24. An epitaxial wafer comprising:
the substrate according to any one of claims 19 to 22; and
one or more nitride semiconductor layers epitaxially grown on the substrate.

25. A method of producing a nitride semiconductor device, the method comprising the steps of:
providing the substrate according to any one of claims 19 to 22; and
epitaxially growing one or more nitride semiconductor layers on the provided substrate.

26. The method of producing a nitride semiconductor device according to claim 25, which is a method of producing a GaN-HEMT.
